# EUROPEAN PATENT SPECIFICATION

(11) **EP 0 834 931 B1**
(45) Date of publication and mention of the grant of the patent: **12.09.2001**
(21) Application number: 97118391.8
(22) Date of filing: 26.03.1993
(51) Int. Cl.: H01L 39/24, C04B 35/45

(54) **Oxide superconductor having large magnetic levitation force and its production method**
Oxidsupraleiter mit grosser magnetischer Schwebekraft und Verfahren zu seiner Herstellung
Supraconducteur d'oxyde ayant une grande force de lévitation magnétique et méthode de fabrication

(30) Priority: 27.03.1992 JP 10195392; 27.03.1992 JP 10195592; 06.04.1992 JP 11302392; 19.06.1992 JP 16137192
(43) Date of publication of application: 08.04.1998
(62) Divisional of application: 93105034.8
(73) Proprietor: INTERNATIONAL SUPERCONDUCTIVITY TECHNOLOGY CENTER, Minato-ku, Tokyo-to (JP); KAWASAKI JUKOGYO KABUSHIKI KAISHA, Chuo-ku, Kobe-shi, Hyogo-ken (JP); HOKURIKU ELECTRIC POWER COMPANY, Toyama-ken (JP); NIPPON STEEL CORPORATION, Chiyoda-ku Tokyo-to (JP); Railway Technical Research Institute, Kobubunji-shi Tokyo-To (JP)
(72) Inventor: Kondoh, Akihiro, Hyogo-ku, Kobe-shi, Hyogo-ken (JP); Murakami, Masato, Koto-ku, Tokyo-To (JP); Koshizuka, Naoki, Koto-ku, Tokyo-To (JP); Tanaka, Shoji, Koto-ku, Tokyo-To (JP); Kagiya, Shoichi, Koto-ku, Tokyo-To (JP); Fujimoto, Hiroyuki, Koto-ku, Tokyo-To (JP)
(74) Representative: Hassler, Werner, Dr.

(56) References cited:
- EP-A- 0 486 698
- MITSURU MORITA ET AL: "EFFECT OF PT ADDITION ON MELT-PROCESSED YBACUO SUPERCONDUCTORS" JAPANESE JOURNAL OF APPLIED PHYSICS, vol. 30, no. 5A PART 02, 1 May 1991, pages L813-L815, XP000237011
- MASATO MURAKAMI ET AL: "LARGE LEVITATION FORCE DUE TO FLUX PINNING IN YBACUO SUPERCONDUCTORS FABRICATED BY MELT-POWDER-MELT-GROWTH PROCESS" JAPANESE JOURNAL OF APPLIED PHYSICS, vol. 29, no. 11, 1 November 1990, pages L1991-L1994, XP000224041

## Description

### BACKGROUND OF THE INVENTION

### - Field of the Invention -

The present invention relates generally to the production of a REBaCuO oxide superconductor having large magnetic levitation force, which is intended for application to flywheels, magnetic bearings, delivery systems, etc., due to magnetic levitation. Throughout the disclosure, RE stands for a rare earth element or elements selected from the group consisting of Y, Sm, Eu, Gd, Dy, Ho, Er, and Yb.

### - Prior Art -

In recent years, REBaCuO superconducting oxides have started to be used for application to flywheels, etc., by magnetic levitation. These superconductors, for instance, have been fabricated by the melt powder melt growth (MPMG) technique - see H. Fujimoto and co-workers, "Proc. of ISS '89", Springer - Verlag, p. 285, 1990.

Set out just below is one typical example of superconductor production by this technique. First, the raw materials, e.g., Y₂O₃, BaCO₃ and CuO, are mixed together at a predetermined ratio. The mixture may have been calcined and pulverized. Further, the mixture is heated to a temperature at which RE₂O₃ and liquid phases coexist, e.g., 1,400°C for partial melting (M). Subsequently, the melt is cooled for solidification. This is followed by pulverization (P), mixing, and shaping. The shape is then heated to a temperature at which an RE₂BaCuO₅ phase (hereinafter referred to simply as the 211 phase) and a liquid phase coexist, e.g., 1,100°C for partial melting (M). After this, the partial melt is cooled to a temperature at which a superconducting REBa₂Cu₃O_{d} phase (hereinafter simply called the 123 phase) occurs, from which it is slowly cooled at a predetermined rate, e.g., 1°C per hour, thereby forming and growing (G) the 123 phase for superconductor production.

A superconductor fabricated with the use of this technique shows a high critical current density, and exhibits large magnetic levitation force as well, due to large superconducting crystal size - see M. Murakami and co-workers, "Japanese Journal of Applied Physics", Vol. 29, No. 11, p. 1991, 1990. In order to achieve high magnetic levitation force, it is thus required to increase the size of superconducting crystals having high critical current densities.

The high critical current density mentioned above has been achieved by dispersing the 211 phase finely throughout the 123 phase. According to some report, the smaller the 211 phase size, the higher the critical current density is - see M. Murakami and co-workers, "Proc. of M²S HTSC III Conference", 1991. Thus, to disperse the 211 phase throughout the 123 phase and to increase the size of the 211 phase can provide one important means for obtaining high critical current densities.

However; the MPMG technique involves the steps of heating the raw materials for partial melting, cooling the melt, followed by pulverization and mixing, shaping the mixture, heating the shaped body for partial melting, and slowly cooling the melt for superconductor production. Thus, this process is lengthy and complicated, and so there is strong demand for simplifying it.

So far, such superconductors have also been produced by other techniques such as the MTG (melt textured growth) technique - see S. Jin and co-workers, "Appl. Phys. Lett.", Vol. 52, No. 207, 1988. Set out just below is one typical example of superconductor production by the MTG technique. First, the raw powders are formulated into a composition REBa₂Cu₃O_{d}, followed by shaping. The shaped body is partially melted, and then slowly cooled with some temperature gradient for superconducting phase growth. After this, the superconducting phase is annealed in an oxygen-enriched atmosphere, thereby adding oxygen to the superconducting phase. However, the thus produced superconductor is found to have a low critical current density and so fail to achieve high-enough magnetic levitation force.

Recently, N. Ogawa and co-workers have also come up with the PDMG (platinum doped melt growth) technique making use of the addition of platinum or Pt - see "Physica C177", p. 101, 1991. Set out just below is one typical example of superconductor production by the PDMG technique. First, platinum or a platinum compound (P) is added (D) to the raw powders, when they are mixed together. Following this, the mixture is shaped. Then, the shaped body is partially melted (M) according to the rear MG part of the MPMG technique mentioned above for the growth (G) of the 123 phase. The superconductor fabricated by this PDMG technique has a structure in which the 211 phase is finely dispersed throughout the 123 phase, and shows a high critical current density. With this technique, however, it is difficult to increase superconductor crystal size; in other words, no considerable increase in magnetic levitation force is still achievable.

According to some report, the addition of silver leads to an increase in superconductor crystal size. However, the crystal size is at most 0.5 mm - see C. Y. Huang and co-workers, "Modern Physics Letters B", Vol. 3, No. 6, p. 525, 1989.

N. Ogawa and co-workers have recently come up with the addition of cerium oxide to the raw materials - see "ISS '91 PROGRAM & ABSTRACTS". Set out just below is a typical example of superconductor production by this method. First, cerium oxide is added to the raw powders, when they are mixed together. Following this, the mixture is shaped. Then, the shaped body is partially melted according to the MG technique that is a rear part of the MPMG technique for the growth of the 123 phase. The thus produced superconductor is found to have an improved critical current density. A grave problem with this method, however, is that some considerable difficulty is involved in increasing the size and, hence, magnetic levitation force of superconductor crystals, because it is impossible to place the formation and growth of superconductor crystals, i.e., the 123 phase under control.

According to some report, another recently developed method for increasing superconductor crystal size or the QMG (quench and melt growth) technique - see M. Murakami and co-workers, "Japanese Journal of Applied Physics", Vol. 28, No. 7, 1988 - has well succeeded in achieving crystal size increases by seeding a SmBa₂Cu₃O_{d} single crystal - that is produced by the QMG technique and then cleaved- in precursor - to which a Yb-Y composition gradient is imparted with a Yb₁₋ₓYₓBa₂Cu₃O_{d} composition - at around 1,030°C (in the cooling process from the partial melting to the initiation of the slow cooling for forming and growing the superconducting phase). For this, see M. Morita and co-workers, "Proc. of ISS '90", Springer-Verlag, p. 733, 1991. A patent specification directed to this method has already been published for public inspection (under No. WO91/19029). However, this method is unfit for mass production, because much time and labor are needed for fabricating the precursor having a composition gradient, producing the above seed single crystal, and placing it on the precursor.

Mitsuru Morita et al: Effect of PT addition on melt-Processed YBaCuO Superconductors Japanese Journal of applied Physics, vol. 30, no. 5a Part 02,1 May 1991, pages L813-L815, XP000237011 describes a production of YBaCuO superconductors by a process using as starting material a combination of Y₂O₃, BaCuO₂ and BaCu₂O₂.The powders are mixed, shaped, partially melted, cooled and slowly cooled at rate of 1 °C/h. Different amounts of Pt are added to the precursor.

The EP-A-0 486 698 is prior art under art. 54 (3) EPC. Said specification discloses a process in which RE₂BaCuO₅, BaCuO₂ and BaCu₂O₂ powders are mixed, shaped, partially melt, cooled and slowly cooled at a rate of 0,5°C/h. Different amounts of Pt are added to the precursor.

It is thus desired to develop a superconductor having large critical current density and magnetic levitation force, which can be produced by a process shorter and simpler than the MPMG process, and its production process.

In some applications, large superconductor pellets are desired, and so there is strong demand for establishing methods for fabricating such large pellets.

A superconductive material, on the other hand, often presents problems in connection with its thermal stability or mechanical properties.

A superconductive material having unfavorable thermal stability poses the following problem; when it is locally converted into a normal conductor for some unknown reasons to generate heat, it is impossible to remove this heat rapidly by external cooling. This then allows the superconductor to have normal conductivity as a whole and thereby lose its superconductivity. To ward off this, it is desired to improve the thermal stability.

An oxide superconductor, because of being a sort of ceramics, poses a problem in connection with cracking, basically because its toughness is low. The 211 phase dispersed throughout the 123 phase is prima facie effective for inhibiting cracking, but the effect on cracking inhibition is much less than satisfactory, because the 211 phase itself is a ceramic material. Thus, it is desired to improve the mechanical properties.

An object of the present invention is to provide a method that can produce a crack-free superconductor having large magnetic levitation force and having a large crystals and a fine structure in which a phase formed by the above 211 phase and an additive is finely dispersed in the above 123 phase or a superconductor in which the size of the 211 phase dispersed throughout the above 123 phase is reduced and which has a large critical current density, by a process shorter and simpler than the MPMG technique mentioned above and such a superconductor.

The fundamental features of the present invention will be described below in order to achieve the above object.

It has been found that a superconductor produced according to a process which comprises mixing RE₂Cu₂O₅, a barium oxide and a cupper oxide or RE₂Cu₂O₅ and a barium cupper oxide as a starting material, shaping, heating a resulting shape to a temperature at which the above 211 phase and the above liquid phase coexist, partially melting, cooling and slowly cooling thereby forming and growing the above 123 phase, has a smaller size of the 211 phase dispersed in the 123 phase and a larger critical current density and magnetic levitation force than that obtained using a combination of the other usual starting materials, i.e., RE₂O₃, BaO₂ and CuO, or RE₂BaCuO₅ and REBa₂CuO_{d} or RE₂O₃, BaCuO₅ and CuO in the same manner.

### SUMMARY OF THE INVENTION

The present invention also relates to a method for producing an REBaCuO superconductor, where RE stands for a rare earth element selected from the group consisting of Y, Sm, Eu, Gd, Dy, Ho, Er, and Yb, by mixing together REBaCuO oxide, a Ba oxide and Cu oxide or said REBaCuO and BaCu oxide, shaping the mixture, partially melting the shaped body, and cooling and slowly cooling the partial melt by a cooling rate of 0,2 to 20 °C per h for the formation and growth of the superconductor.

A fundamental heat treatment for producing a superconductor includes partially melting, cooling and slowly cooling for the formation and growth the superconducting phase.

### BRIEF DESCRIPTION OF THE DRAWINGS

The features of the invention which are believed to be novel are particularly pointed out and distinctly claimed in the concluding portion of this specification. However, the invention may be best appreciated by reference to the following detailed description taken in conjunction with the drawings, in which:
FIGURE 1 is a micrograph of the crystals of a superconductor made up of Y₂Cu₂O₅, and Ba and Cu oxides according to the invention,
FIGURE 2 is a micrograph of the crystals of a superconductor made up of Y₂BaCuO₅ and YBa₂Cu₃O_{d},
FIGURE 3 is a micrograph of the crystals of a superconductor made up of Y₂BaCuO₅, BaCuO₂ and CuO,
FIGURE 4 is a micrograph of the crystals of a superconductor made up of Y₂O₃, BaCuO₂ and CuO,
FIGURE 5 is a micrograph of the crystals of a superconductor obtained by the addition of platinum to the raw materials according to the invention,
FIGURE 6 is a micrograph of the crystals of a superconductor obtained by the addition of rhodium to the raw materials according to the invention, and
FIGURE 7 is a micrograph of the crystals of a superconductor obtained by the addition of cerium oxide to the raw materials according to the invention.

### DETAILED DESCRIPTION OF THE PREFERRED EMBODIMENTS

Set out just below is one typical example of the process of the method for superconductor production according to the invention.

### Step 1

At the first step for REBaCuO superconductor production, the precursor prior to shaping is prepared. As RE, at least one rare earth element selected from the group consisting of Y, Sm, Eu, Gd, Dy, Ho, Er, and Yb is used. The raw powders namely combinations of RE₂Cu₂O₅, Ba oxides and Cu oxides, or combinations of RE₂Cu₂O₅ and BaCu oxides may be mixed together at a predetermined ratio to prepare a powder mixture comprising REBaCuO.

It is then possible to better critical current densities by the addition of 0.1 to 2% by weight of platinum or a platinum compound, 0.01 to 2% by weight of rhodium, or 0.1 to 2% by weight of a cerium oxide. The platinum compound used, for instance, may be Pt₂Ba₄CuO₉, and the cerium oxide used, for instance, may be CeO₂, and CeBaO₃.

### Step 2

The powder mixture obtained at Step 1 is shaped into a desired shape to make a formed body.

When a large, or a rectangular or other body is made, it is preferable that the mixture is first preshaped at a relatively low pressure and then isotropically pressed at a good-enough pressure. This is because the body being shaped is prevented from cracking, which may otherwise result in a decrease in the magnetic levitation force of the produced superconductor. In other words, it has now been found that the body being shaped can be ketp from cracking by isotropic pressing.

### Step 3

It is preferable to use the nucleants, but the nucleants can be dispensed with in order to improve critical current density in the invention. Powders or single crystals are placed or embedded as the nucleants somewhere on or in the shaped body, as desired. For embedding, the nucleants may be located somewhere in the shaped body. This step may be done anytime until just before the start of slow cooling or the next step 4. However, this should preferably be done here, because it then takes less time and labor.

On the other hand, the nucleants can produce its own effect sufficiently in an amount of at most about 10 mg. The nucleants used, for instance, may be at least one member selected from the group consisting of Y₂O₃, Nd₂O₃, Sm₂O₃, Eu₂O₃, La₂O₃, Gd₂O₃, Dy₂O₃, Ho₂O₃, Er₂O₃, Y₂BaCuO₅, Sm₂BaCuO₅, Eu₂BaCuO₅, Gd₂BaCuO₅, Dy₂BaCuO₅, Ho₂BaCuO₅, Er₂BaCuO5, YBa₂Cu₃O_{d}, NdBa₂Cu₃O_{d}, LaBa₂Cu₃O_{d}, EuBa₂Cu₃O_{d}, GdBa₂Cu₃O_{d}, DyBa₂Cu₃O_{d}, HoBa₂Cu₃O_{d}, and ErBa₂Cu₃O_{d}. A superconducting phase i.e., the 123 phase is preferentially formed and grown from this nucleation site.

### Step 4

The shaped body with the nucleants placed on or embedded in it, or nothing on it, is heated at a temperature lying in the range of 950 to 1,250°C at which the 211 phase forms, and then retained at that temperature for 15 to 90 minutes, from which it is cooled down to a temperature somewhat higher than the temperature at which the 123 phase mentioned above starts to form from the 211 and liquid phases mentioned above, e.g., to a temperature somewhat higher than 1,000°C when RE is Y and the atmosphere is air, at a cooling rate of 10 to 1,000°C per hour. Subsequently, the shaped body is slowly cooled from this temperature down to 850 to 950°C at a cooling rate of 0.2 to 20°C per hour. Why the slow cooling is done from the temperature mentioned above is that when this temperature is low, the 123 phase is most likely to form wherever it forms. It is desired that the low cooling be carried out with some temperature gradients. In this case, it is preferable that a temperature gradient of 1°C/cm or more is set around the location of the shaped body on or in which the nucleants are placed or embedded, whereby the temperature of that location reaches a low.

### Step 5

Following Step 4, the product may be cooled from 850 to 950°C down to room temperature at any desired cooling rate.

If required, the thus fabricated superconductor may be retained at a temperature lying in the range of 650 to 300°C for 2 to 500 hours, or may be cooled from a high of 650°C to a low of 300°C over 2 to 500 hours, in an oxygen-enriched atmosphere, thereby adding sufficient oxygen thereto. After this, it may be cooled at any desired cooling rate.

This makes it possible to obtain a superconductor which has large magnetic levitation force or a high critical current density.

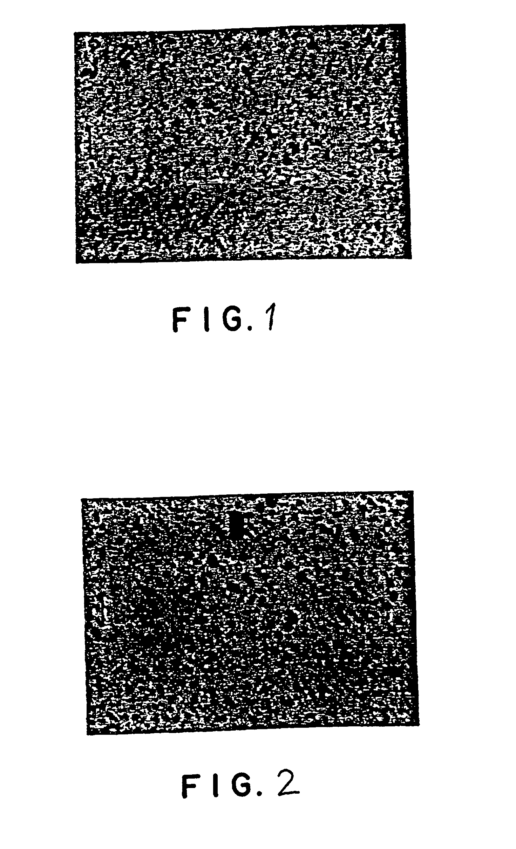

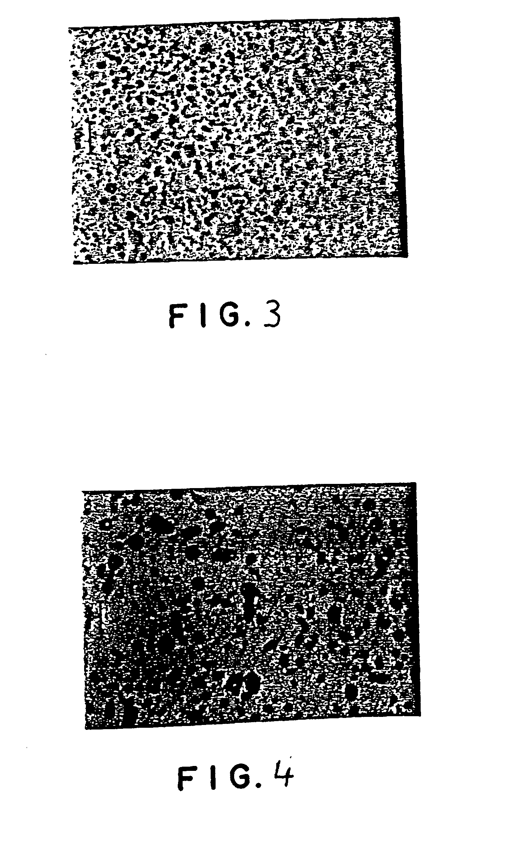

Fig. 1 is a polarizing micrograph of the structure of a superconductor fabricated according to the invention, using RE₂Cu₂O₅ where RE = Y, BaO₂ and CuO as the raw materials according to the third aspect of the invention. Figs. 2 - 4 are polarizing micrographs of the structures of comparative superconductors that are fabricated using conventional raw materials and without recourse to the invention. It can be seen that the 211 phase dispersed throughout the 123 phase, shown in Fig. 1, is smaller in size than those dispersed the superconductive 123 phases made up of the conventional raw materials, shown in Figs. 2 to 4

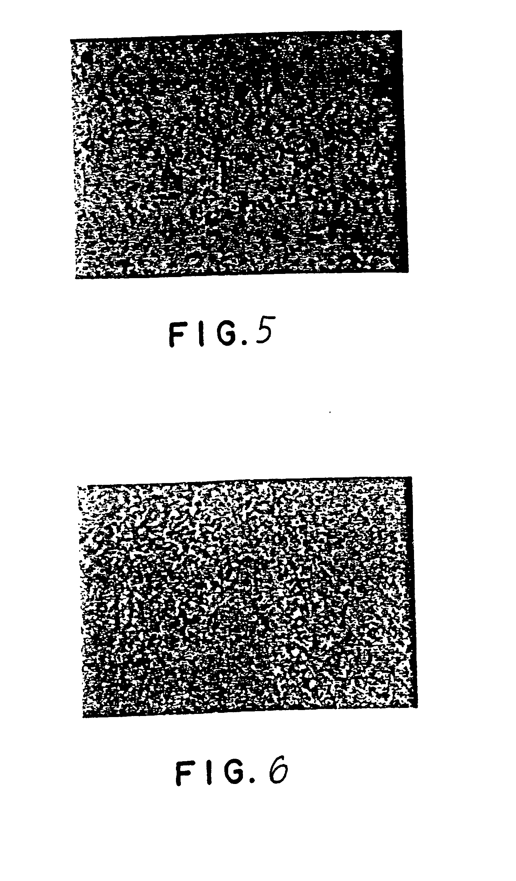

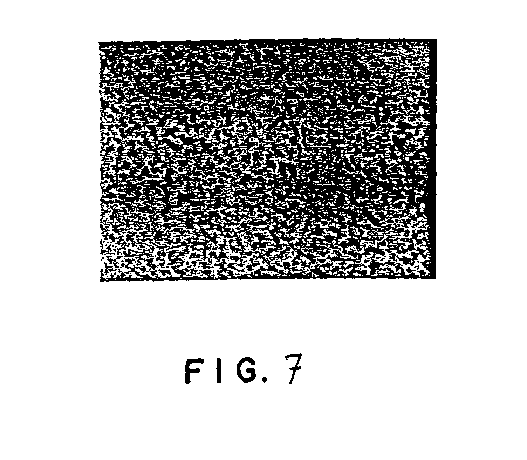

Figs. 5 to 7 are polarizing micrographs of the structures of superconductors fabricated according to the invention, using the raw powders, Y₂Cu₂O₅, BaO₂ and CuO that contain platinum, rhodium and cerium oxide each in an amount of 0.5% by weight. The 211 phases dispersed throughout the superconductive 123 phases, fabricated with the addition of the above additives according to the invention and shown in Figs. 5 to 7, are as small as that dispersed throughout the superconductive 123 phase fabricated with no additive, shown in Fig. 1.

Therefore, it is evident that the size of the 211 phase dispersed in the 123 phase of the superconductor obtained according to the present invention is smaller than that of the superconductor obtained according to the methods other than the present invention. Thus, it has become possible to produce a superconductor having high critical current density and large magnetic levitation force.

Thus, the superconductor obtained according to the invention is smaller than those obtained without recourse to the invention in terms of the size of 211 phase dispersed throughout the 123 phase. Accordingly, it is obvious that the present superconductor is increased in terms of critical current density and magnetic levitation force as well. In addition, the invention makes it possible to obtain such superconductors by a simple production process, and so makes a breakthrough in the art.

### EXAMPLES

The following examples and comparative examples are intended to illustrate the invention and not to limit the scope of the invention in all its aspects.

### Example 1.

The starting materials, Y₂Cu₂O₅, BaO₂ and CuO, were mixed together at a Y:Ba:Cu ratio of 1.8:2.4:3.4. The mixture was formed, heated at 1,030°C for 20 minutes, cooled down to 1,000°C over 2 minutes, and slowly cooled down to 890°C at 1°C per 1 hour, followed by furnace cooling. The product was further heated at 600°C for 1 hour in a 1-atm oxygen stream, and finally subjected to furnace cooling to make a superconductor.

Figure 1 is a polarizing micrograph of the crystals of the thus obtained superconductor.

Apart from this superconductor, three sets of the conventional starting materials, Y₂BaCuO₅ and YBa₂Cu₃Oₓ, Y₂BaCuO₅, BaCuO₂ and CuO, and Y₂O₃, BaCuO₂ and CuO, were similarly used to make three superconductors, the structures of which are shown in the polarizing micrographs of Figs. 2 , 3 and 4, respectively.

A comparison of these photographs indicates that the size of Y₂BaCuO₅ dispersed throughout the crystals of the superconductor of the invention shown in Fig. 1 is smaller than those of the superconductors obtained from the conventional starting materials, shown in Figs. 2 to 4.

### Example 2

Starting from the same materials as in Example 1 , a superconductor was made, following the procedure of Example 1. As set out in Table 1, the superconductor starting from Y₂Cu₂O₅, BaO₂ and CuO was higher than those starting from conventional raw materials in terms of the critical current density, as found by measuring magnetization at 77 K and 1 T (tesla).

### Example 3

Superconductor pellets were fabricated according to the procedure of Example 1. Pellet size was about 16 mm in diameter and about 7 mm in height. As measured with a permanent magnet having a diameter of 12 mm and a surface flux density of 0.4 T, the pellet starting from Y₂Cu₂O₅, BaO₂ and CuO was higher in magnetic levitation force than those of the pellets produced with conventional starting materials, as set out in Table 2.

### Example 4

Following the procedure of Example 1, superconductors were fabricated with REs other than Y, i.e., Sm₂Cu₂O₅, Eu₂Cu₂O₅, Gd₂Cu₂O₅, Dy₂Cu₂O₅, Ho₂Cu₂O₅, Eu₂Cu₂O₅, and Yb₂Cu₂O₅. Table 3 sets out the critical current densities of the obtained superconductors, as found by measuring their magnetizations at 77 K and 1 T. The effect of the invention is found in all the RE systems.

### Example 5

Superconductors were fabricated following the procedure of Example 1, with the exception that platinum, rhodium, and cerium oxide, each in an amount of 0.5% by weight, were added to the starting materials. Table 4 sets out the critical current densities of the obtained superconductors, as measured according to the procedure of Example 4 and indicates that the critical current densities of superconductors are much higher in the presence of these additives than in the absence.

### Example 6

The starting materials, Y₂Cu₂O₅, BaO₂ and BaCuO₂, were mixed together at a Y:Ba:Cu ratio of 1.8:2.4:3.4. The mixture was shaped, heated at 1,030°C for 20 minutes, cooled down to 1,010°C over 20 minutes, and slowly cooled down to 880°C at 1°C per hour with a temperature gradient selected from 1°C/cm, 5°C/cm, and 9°C/cm in such a way that the temperature of the lower surface of the pellet reached a low, followed by furnace cooling.

The pellet was further heated at 600°C for 1 hour in a 1-atm oxygen stream, and finally subjected to furnace cooling to make a superconductor.

As measured according to the procedure of Example 30, these superconductors had high magnetic levitation force, as set out in Table 5.

**Table 1**

| Starting Materials, and Critical Current Density | |
|---|---|
| Starting Materials | CCD (77K, 1 T), A/cm² |
| Y₂Cu₂O₅ + BaO₂ + CuO | 11,500 |
| Y₂BaCuO₅ + YBa₂Cu₃Oₓ | 8,000 |
| Y₂BaCuO₅ + BaCuO₂ + CuO | 7,800 |
| Y₂O₃ + BaCuO₂ + CuO | 6,000 |

**Table 2**

| Starting Materials, and Magentic Levitation Force | |
|---|---|
| Starting Materials | Magnetic Levitation Force, kgf |
| Y₂Cu₂O₅ + BaO₂ + CuO | 0.72 |
| Y₂BaCuO₅ + YBa₂Cu₃Oₓ | 0.28 |
| Y₂BaCuO₅ + BaCuO₂ + CuO | 0.26 |
| Y₂O₃ + BaCuO₂ + CuO | 0.27 |

**Table 3**

| Substituent, and Critical Current Density | |
|---|---|
| Substituent for Y | Critical Current Density (77 K, 1 T) A/cm² |
| Sm | 11,000 |
| Eu | 10,500 |
| Gd | 10,000 |
| Dy | 10,500 |
| Ho | 11,000 |
| Er | 10,000 |
| Yb | 9,500 |

**Table 4**

| Critical Current Density per Additive | |
|---|---|
| Addtivie, 0.5 wt% | Critical Current Density (77 K, 1 T) A/cm² |
| Platinum | 17,500 |
| Rhodium | 18,000 |
| Cerium Oxide | 16,500 |

**Table 5**

| Magnetic Levitation Force per Temp. Gradient | |
|---|---|
| Temp. Gradient, °C/cm | Magnetic Levitation Force, kgf |
| 1 | 1.10 |
| 5 | 1.05 |
| 9 | 0.91 |

## Claims

1. A method for producing an REBaCuO superconductor, where RE stands for a rare earth element selected from the group consisting of Y, Sm, Eu, Gd, Dy, Ho, Er, and Yb, by mixing together RE₂Cu₂O₅ a Ba oxide and Cu oxide or said RE₂Cu₂O₅ and BaCu oxide, shaping the mixture, partially melting the shaped body, and cooling and slowly cooling the partial melt by a cooling rate of 0,2 to 20 °C per h for the formation and growth of the superconductor.

2. A method as claimed in claim 1 wherein, platinum, a platinum alloy, or a rhodium or cerium oxide is further used as an additive.

## Patentansprüche

1. Verfahren zur Herstellung eines REBaCuO-Supraleiters mit RE als ein seltenes Erdelement ausgewählt aus der Gruppe Y, Sm, Eu, Gd, Dy, Ho, Er und Yb durch Mischen von RE₂Cu₂O₅, einem Ba-Oxid und Cu-Oxid oder dem RE₂Cu₂O₅ und BaCu-Oxid, Ausformen der Mischung, teilweises Aufschmelzen des geformten Körpers, Kühlen und langsames Abkühlen der Partialschmelze mit einer Abkühlgeschwindigkeit von 0,2 bis 20 °C/h zur Ausbildung und zum Wachstum des Supraleiters.

2. Verfahren nach Anspruch 2, wonach Platin, eine Platinlegierung oder ein Rhodium- oder Ceroxid als weiterer Zusatzstoff benutzt werden.

## Revendications

1. Un procédé de fabrication d'un supraconducteur de REBaCuO, où RE désigne un élément de terre rare choisi dans le groupe se composant de Y, Sm, Eu, Gd, Dy, Ho, Er et Yb, par les étapes consistant à mélanger entre eux RE₂Cu₂O₅, un oxyde de Ba et un oxyde de Cu ou ledit RE₂Cu₂O₅ et un oxyde de BaCu, conformer le mélange, faire partiellement fondre le corps conformé, et refroidir lentement le produit partiellement fondu à une vitesse de refroidissement de 0,2 à 20°C par h pour la fabrication et la croissance du supraconducteur.

2. Un procédé tel que revendiqué à la revendication 1, dans lequel du platine, un alliage de platine ou un oxyde de rhodium ou de cérium est en outre utilisé en tant qu'additif.
